(19) Europäisches Patentamt
European Patent Office
Office européen des brevets

(11) Veröffentlichungsnummer: **0 262 411**
**A1**

(12) # EUROPÄISCHE PATENTANMELDUNG

(21) Anmeldenummer: 87112557.1

(51) Int. Cl.⁴: **G11C 8/00**

(22) Anmeldetag: 28.08.87

(30) Priorität: 01.09.86 DE 3629694

(43) Veröffentlichungstag der Anmeldung:
06.04.88 Patentblatt 88/14

(84) Benannte Vertragsstaaten:
AT DE FR GB IT NL

(71) Anmelder: **Siemens Aktiengesellschaft Berlin und München**
**Wittelsbacherplatz 2**
**D-8000 München 2(DE)**

(72) Erfinder: **Stronski, Sabine**
**Tannenweg 39**
**D-8055 Goldach(DE)**
Erfinder: **Renner, Franz**
**Rablstrasse 12**
**D-8000 München 80(DE)**

(54) **Adressdecoder für CMOS-Schaltkreise.**

(57) Zur Verkürzung der Schaltzeiten von Adreßdecodern für CMOS-Schaltkreise werden dynamische Logikglieder vorgeschlagen, die durch nachgeschaltete Halteglieder quasistatisches Verhlaten zeigen. Die dynamischen Logikglieder werden wie der Adreßbus in einer Taktphase vorgeladen, während in einer zweiten Taktphase die Adressen mit Hilfe schneller n-Kanal-Transistoren ausgewertet und in dem zugeordneten Halteglied zwischengespeichert werden.

FIG 2

EP 0 262 411 A1

## Adreßdecoder für CMOS-Schaltkreise

Die Erfindung betrifft einen Adreßdecoder für CMOS-Schaltkreise nach dem Oberbegriff des Patentanspruchs 1.

Das Zusammenwirken der einzelnen Bauelemente einer digittalen Schaltungsanordnung, z.B. einem Mikrocomputer in CMOS-Technik, gewährleisten interne Busse, über die Daten und Steuersignale ausgetauscht werden. Diese Busse besitzen eine bestimmte Bitbreite, z.B. 8 Bit oder ein Vielfaches davon. Beispielsweise zur Steuerung einzelner Funktionsgruppen oder zur Auswahl der Zellen eines Halbleiterspeichers dient der Adreßbus, mit dessen Hilfe diejenige Funktionsgruppe oder Speicherzelle angesprochen wird, die eine bestimmte vorgesehene Aufgabe oder Speicherinformation ausführen oder verarbeiten soll. Die Adressen, die über den internen Adreßbus übertragen werden, sollen innerhalb eines vorgegebenen Zeitbereichs decodiert werden.

Jedes Bussystem stellt physikalisch relativ hohe Kapazitäten dar, da die Leitungen des Busses im gesamten Baustein verzweigt sind. Zur Verkürzung der Adreßdecodierzeit werden deshalb diese Leitungen üblicherweise mit einem Takt PH1 vorgeladen und mit einem, den Takt PH1 nicht überlappenden Takt PH2 ausgewertet. Dabei wird die Tatsache ausgenutzt, daß eine Leitung technisch leichter von einem hohen auf einen niedrigen Pegel heruntergezogen als von einem niedrigen auf einen hohen Pegel gebracht werden kann. Das Ergebnis der Adreßdecodierung soll noch während der Taktdauer des Taktes PH2 in einem Halteglied zwischengespeichert werden.

Abhängig von der vorgegebenen maximalen Betriebsfrequenz für die digitale Schaltungsanordnung weisen die Takte PH1 und PH2 minimale Periodendauern auf. Für die bisher üblichen Betriebsfrequenzen konnten zur Realisierung eines Adreßdecoders statische Logikglieder genutzt werden, deren Schaltzeiten ausreichend kurz waren.

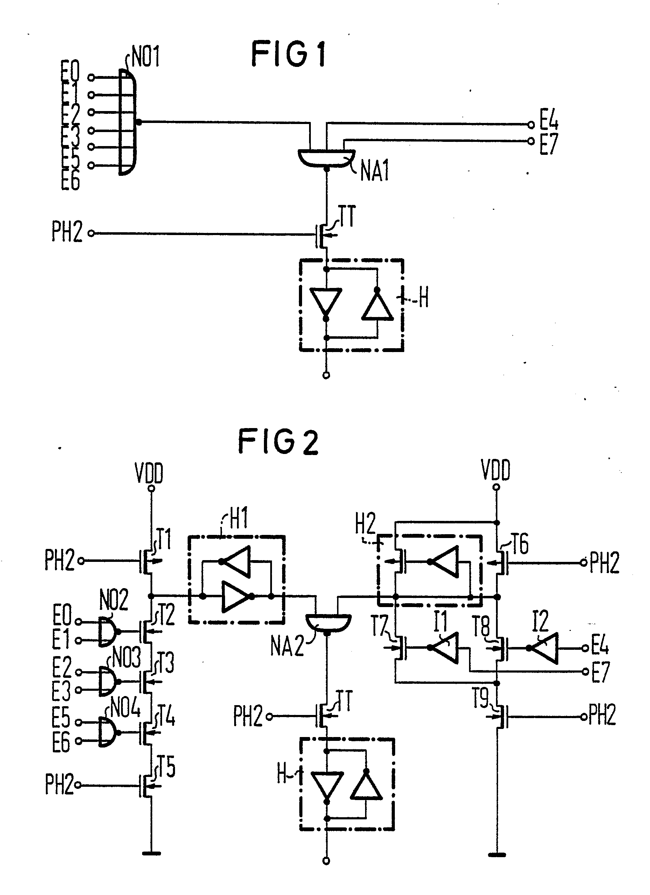

Fig. 1 zeigt einen Adreßdecoder nach dem Stand der Technik, der eine bestimmte Adresse eines hexadezimalen Codes bei 8 Bit breitem Adreßbus erkennt. An dem logischen NOR-Glied NO1 liegen die Adreßleitungen E0 bis E3 und E5 sowie E6. Der Ausgang des Gliedes NO1 bildet zusammen mit den restlichen beiden Adreßeingängen E4 und E7 den Eingang eines NAND-Gliedes NA1, an dessen Ausgang die durch die beiden Logikglieder verknüpfte logische Adresse zur Verfügung steht. Beim Anlegen des Auswertetaktes PH2 an den Steuereingang des Transfertransistors TT wird diese Adresse zur Zwischenspeicherung in das Halteglied H übernommen. Das Halteglied enthält einen Inverter, dessen Ausgang einen Ausgang des gesamten Adreßdecoders bildet, der über einen weiteren hochohmigen Inverter auf den Eingang des Inverters rückgekoppelt ist.

Logikglieder mit derart vielen Eingängen wie im Ausführungsbeispiel das NOR-Glied NO1 - oder aber im ungünstigsten Fall ein einziges Gatter mit einer der Bitbreite des Adreßbusses entsprechenden Anzahl von Eingängen - sind in CMOS-Technik vom Layout her sehr platzintensiv und von den Schaltzeiten her äußerst langsam. Ein wichtiger Faktor ist dabei die Realisierung von NOR-Gliedern in CMOS-Technik, bei denen Transistoren vom p-Kanal-Typ jeweils mit ihren Ausgangskreisen in Reihe geschaltet und Tranistoren vom n-Kanal-Typ jeweils mit ihren Ausgangskreisen parallel und in Reihe zur Serienschaltung der p-Kanal-Transistoren angeordnet sind. Ein Nachteil ist nun die Reihenschaltung der p-Kanal-Transistoren, die einen vergleichsweise hohen Widerstand darstellt, wobei die Schaltzeiten von p-Kanal-Transistoren sowieso - schon etwa um die Hälfte langsamer als die Schaltzei ten von n-Kanal-Transistoren sind. Somit ergeben sich aufgrund der kapazitiven Belastung relativ lange Vorladezeiten. Ein weiterer Grund für den hohen Zeitbedarf der Adreßdecodierung mit statischen Logikgliedern liegt darin, daß die Logikglieder erst dann schalten, wenn die Adressen stabil sind.

Rein dynamische Adreßdecoder eignen sich zwar für hohe Betriebsfrequenzen, da andererseits digitale Schaltungsanordnungen oft mit unterschiedlichen, insbesondere gegenüber der maximalen Betriebsfrequenz auch wesentlich niedrigeren Frequenzen betrieben werden, geht bei dynamischen Decodern die Adreßinformation aufgrund der unvermeidbaren Überkoppelkapazitäten und Leckströme relativ schnell verloren, sofern nicht Maßnahmen zur Auffrischung der Adreßinformationen vorgesehen sind.

Der Erfindung liegt die Aufgabe zugrunde, einen Adreßdecoder für CMOS-Schaltkreise anzugeben, der sich sowohl für hohe als auch für niedrige Betriebsfrequenzen eignet und gegenüber Adreßdecodern mit statischen Logikgliedern weniger Platz beansprucht.

Diese Aufgabe wird bei einem Adreßdecoder der eingangs genannten Art erfindungsgemäß durch die Merkmale des kennzeichnenden Teils des Patentanspruchs 1 gelöst wird.

Die Erfindung besitzt den Vorteil, daß durch die Haltekreise am Ausgang der dynamischen Logikglieder ein quasistatischer Betrieb ohne floatenden Ausgang des Adreßdecoders gewährleistet ist. Im Gegensatz zu den starren statischen Logikgliedern läßt sich ein erfindungsgemäßer Adreßdecoder in seiner Struktur sehr regulär gestalten und ohne größere Layout-Anstrengungen in anderen Adreßdecodern einsetzen.

Ausgestaltungen der Erfindung sind in Unteransprüchen gekennzeichnet.

Die Erfindung wird im folgenden anhand der Fig. 2 der Zeichnung näher erläutert, die als Ausführungsbeispiel die erfindungsgemäße Decoderschaltung für die gleiche Adresse wie in Fig. 1 angibt. Der gesamte Adreßdecoder enthält dann eine Vielzahl entsprechender Adreßdecoderschaltungen, mit denen sämtliche zu decodierenden Adressen erkannt werden können.

Gemäß Fig. 2 enthält die erfindungsgemäße Adreßdecoderschaltung ein dynamisches NAND-Logikglied aus den Transistoren T1 bis T5, deren Ausgangskreise in Serie hintereinander liegen, wobei ein Ausgangsanschluß des Transistors T1 am Versorgungspotential VDD und ein Ausgangsanschluß des Transistors T5 am Bezugspotential liegt. Den Ausgang des NAND-Gliedes bildet der Verbindungspunkt der Ausgangskreise der Transistoren T1 und T2. Die Transistoren T1 und T5 werden vom Takt PH2 gesteuert. Die Steuerkreise der Transistoren T2 bis T4 sind über jeweils ein logisches NOR-Glied NO2 bis NO4 mit den Eingängen E0 bis E3 und E5 sowie E6 verbunden, an denen jeweils Leitungen des Adreßbusses angeschlossen sind. Erfindungsgemäß ist dem Ausgang des NAND-Gliedes ein Halteglied H1 nachgeschaltet, das dem Halteglied H gemäß Fig. 1 entspricht.

Weiterhin enthält Fig. 2 erfingungsgemäß ein dynamisches NOR-Glied aus den Transistoren T6 bis T9. Die Ausgangskreise der Transistoren T7 und T8 sind parallel geschaltet. In Serie zu dieser Parallelschaltung liegt einerseits der Ausgangskreis des Transistors T6 gegen das Versorgungspotential VDD und andererseits der Ausgangskreis des Transistors T9 gegen das Bezugspotential. Die Steuerkreise der Transistoren T7 und T8 sind über die Eingänge E4 und E7 mit den entsprechenden Leitungen des Adreßbusses verbunden, wobei zwischen den Gates der Transistoren und den Eingängen E4 und E7 jeweils ein Inverter E1 bzw. E2 geschaltet ist, um die Funktion der Schaltung zu gewährleisten. Die Steuerkreise der Tranistoren T6 und T9 werden entsprechend den Transistoren T1 und T5 des NAND-Gliedes vom Takt PH2 gesteuert.

Den Ausgang des NOR-Gliedes bildet der Verbindungspunkt der Ausgangskreise der Transistoren T6 bis T8. Erfindungsgemäß ist auch diesem dynamischen NOR-Glied ein Halteglied H2 nachgeschaltet, das einen von diesem Ausgang gesteuerten Inverter enthält, der seinerseits einen Transistor vom p-Kanal-Typ steuert, dessen Ausgangskreis mit dem Versorgungspotential VDD einerseits und mit dem Invertereingang und dem Ausgang des dynamischen NOR-Gliedes andererseits verbunden ist.

Das Halteglied H1 ist als invertierendes Halteglied, das Halteglied H2 als nichtinvertierendes Halteglied ausgebildet. Die taktgesteuerten Transistoren T1 und T6 sind vom p-Kanal-Typ, während die taktgesteuerten Tranistoren T5 und T9 vom n-Kanal-Typ sind.

Die Ausgänge der beiden Halteglieder H1 und H2, wobei der Ausgang des Haltegliedes H2 gleichzeitig auch der Ausgang des dynamischen NOR-Gliedes ist, bilden die Eingänge eines statischen NAND-Gatters NA2, an dessen Ausgang die decodierte Adreßinformation zur Verfügung steht. Entsprechend Fig. 1 wird diese Adreßinformation am Ausgang von NA2 über den vom Takt PH2 gesteuerten Transfertransistor TT in das Ausgangs-Halteglied H zur Zwischenspeicherung übernommen, an dessen Ausgang dann die decodierte Adresse abgegriffen wird.

Die dynamischen Logikglieder werden genauso wie die Leitungen des Adreßbusses bei Anliegen des Taktsignals PH1 vorgeladen. Dazu dienen im Ausführungsbeispiel die Transistoren T1 und T6 vom p-Kanal-Typ, die immer dann leiten, wenn ihr Steuereingang bzw. das Taktsignal PH2 auf niedrigem Potential liegen, was dem hohen Potential des Taktes PH1 entspricht. Durch diese Vorladung der Ausgänge der dynamischen Gatter ist eine Invertierung der Bussignale nötig.

Das Halteglied H1 hält durch den rückgekoppelten hochohmigen Inverter den Ausgang des dynamischen NAND-Gliedes auf seinem Potential. Das Halteglied H2 des NOR-Gliedes sichert die Vorladung durch den hochohmigen p-Kanal-Transistor. Dabei liegt der Schaltpunkt des ansteuernden Inverters so hoch, daß der Ausgang des zugeordneten dynamischen Logikgliedes beim Auswerten, d.h. bei anliegendem Takt PH2, ungehindert auf Masse gezogen werden kann.

Eine weitere Verkürzung der Schaltzeiten läßt sich erreichen, wenn die Anzahl der Eingänge der dynamischen Logikglieder möglichst gering wird. Im Ausführungsbeispiel laufen dabei die an den Eingängen E0 bis E3 und E5 sowie E6 des dynamischen NAND-Gliedes angeschlossenen entsprechenden Busleitungen in Zweifach-NOR-Gliedern NO2 bis NO4 zusammen, deren Ausgänge dann jeweils einen Eingang des NAND-Gliedes steuern. Die Verwendung von den Eingängen der dynamischen Logikglieder vorgeschalteten statischen Logikgliedern mit mehr als zwei Eingängen lohnt sich nicht, da dann die bei den dynamischen Logikgliedern gewonnene Schaltzeit bei den statischen Logikgliedern wieder verloren geht. Erfindungsgemäß liegt jedoch der Schaltpunkt der statischen Logikglieder NO2 bis NO4 höher als in der regulären Logik, um die Auswertung weiter zu beschleunigen.

Aufgrund der Tatsache, daß die den Eingängen des erfindungsgemäßen Adreßdecoders bzw. den Busleitungen zugeordneten Transistoren der dynamischen Logikglieder, im Ausführungsbeispiel die Transistoren T2 bis T4 und T7 und T8, ebenso wie die für die Auswertung der Adresse herangezogenen Transistoren T5 und T9 vom n-Kanal-Typ sind, ergibt sich einerseits eine vergleichsweise geringe Schaltzeit, da Transistoren dieses Typs etwa um die Hälfte schneller schalten als Transistoren vom p-Kanal-Typ. Andererseits ist durch die Tatsache, daß für die Vorladung der Ausgänge der dynamischen Logikglieder jeweils nur ein Transistor T1 bzw. T6 vom p-Kanal-Typ vorgesehen ist, daß der Widerstand dieser Transistoren sehr gering ist und eine schnelle Vorladung der Ausgänge erreicht werden kann.

Zur Verknüpfung der Ausgänge der den dynamischen Logikgliedern zugeordneten Halteglieder H1 und H2 ist in der Regel ein weiteres Logikglied vorzusehen, das, wie im Ausführungsbeispiel, statisch arbeiten kann.

**Ansprüche**

1. Adreßdecoder für CMOS-Schaltkreise mit einer der Bitbreite eines angeschlossenen Adreßbusses entsprechenden Anzahl von Eingängen, die für jede mögliche Adresse mit Hilfe jeweils mehrerer Logikglieder logisch verknüpft sind und über einen taktgesteuerten Transfertransistor und ein Halteglied zu jeweils einem einzigen Adreßausgang führen, **gekennzeichnet** durch dynamische Logikglieder (T1 bis T9), denen jeweils ein weiteres Halteglied (H1, H2) nachgeschaltet ist.

2. Adreßdecoder nach Anspruch 1, **dadurch gekennzeichnet**, daß die dynamischen Logikglieder (T1 bis T9) jeweils einen Transistor vom p-(T1, T6) und vom n-Kanal-Typ (T5, T9) enthalten, die vom gleichen Taktsignal wie der Transfertransistor (TT) gesteuert werden, wobei jeweils der Ausgang des p-Kanal-Transistors (T1, T6) den Ausgang des dynamischen Logikgliedes (T1 bis T9) bildet.

3. Adreßdecoder nach Anspruch 1 oder 2, **dadurch gekennzeichnet**, daß in Reihe zum Ausgangskreis des taktgesteuerten n-Kanal-Transistors (T5, T9) der dynamischen Logikglieder (T1 bis T9) Ausgangskreise weiterer n-Kanal-Transistoren (T2 bis T4, T7, T8) liegen, die von den Eingängen des Adreßdecoders (E0 bis E7) gesteuert werden.

4. Adreßdecoder nach Anspruch 1 bis 3, **dadurch gekennzeichnet**, daß die Ausgangskreise der weiteren n-Kanal-Transistoren (T2 bis T4, T7, T8) parallel (T7, T8) oder in Serie (T2 bis T4) geschaltet sind.

5. Adreßdecoder nach Anspruch 1 bis 4, **dadurch gekennzeichnet**, daß den Eingängen der weiteren n-Kanal-Transistoren (T2 bis T4, T7, T8) Logikglieder (NO2 bis NO4, I1, I2) mit höchstens zwei Eingängen vorgeschaltet sind, die einen vergleichsweise hohen Schaltpunkt besitzen.

6. Adreßdecoder nach Anspruch 1 bis 5, **dadurch gekennzeichnet**, daß ein invertierendes Halteglied (H1) einen mit dem Ausgang des dynamischen Logikgliedes (T1 bis T5) verbundenen Inverter mit vergleichsweise hohem Schaltpunkt enthält, dessen Ausgang über einen hochohmigen Inverter auf seinen Eingang zurückgekoppelt ist.

7. Adreßdecoder nach Anspruch 1 bis 5, **dadurch gekennzeichnet**, daß ein nicht invertierendes Halteglied (H2) einen Inverter mit vergleichsweise hohem Schaltpunkt enthält, der einen hochohmigen Tranistor vom p-Kanal-Typ steuert, dessen Ausgangskreis mit einem Versorgungspotential (VDD) einerseits und dem Verbindungspunkt von Invertereingang und Ausgang des dynamischen Logikgliedes (T6 bis T9) andererseits verbunden ist.

8. Adreßdecoder nach Anspruch 1 bis 7, **dadurch gekennzeichnet**, daß zwischen den Ausgängen der weiteren Halteglieder (H1, H2) und dem Transfertransistor (TT) mindestens eine weiteres Logikglied (NA2) angeordnet ist.

## FIG 1

## FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 060 303 (TOKYO SHIBAURA DENKI) * Seite 6, Zeile 125 - Seite 6, Zeile 97; Figuren 9-13 * --- | 1,4-7 | G 11 C 8/00 |
| A | PATENT ABSTRACTS OF JAPAN, Band 8, Nr. 27 (P-252)[1464], 4. Februar 1984; & JP-A-58 182 184 (FUJITSU K.K.) 25.10.1983 * Zusammenfassung * ----- | 1,2,4,5 | |

**RECHERCHIERTE SACHGEBIETE (Int. Cl.4)**

G 11 C    7/00
G 11 C    8/00
G 11 C   11/00

Der vorliegende Recherchenbericht wurde für alle Patentansprüche erstellt

| Recherchenort | Abschlußdatum der Recherche | Prüfer |
|---|---|---|
| DEN HAAG | 02-12-1987 | GEOGHEGAN C.H.B. |